# FASCICULE DE BREVET EUROPEEN

(11) **EP 2 801 118 B1**
(45) Date de publication et mention de la délivrance du brevet: **16.09.2015**
(21) Numéro de dépôt: 12819097.2
(22) Date de dépôt: 19.12.2012
(51) Int. Cl.: H01L 31/18, H01L 31/068

(54) **PROCÉDÉ DE FABRICATION D'UNE CELLULE PHOTOVOLTAÏQUE**
HERSTELLUNGSVERFAHREN FÜR FOTOVOLTAISCHE ZELLEN
PROCESS FOR MANUFACTURING A PHOTOVOLTAIC CELL

(30) Priorité: 05.01.2012 FR 1250105
(43) Date de publication de la demande: 12.11.2014
(73) Titulaire: Commissariat à l'Énergie Atomique et aux Énergies Alternatives, 75015 Paris (FR)
(72) Inventeur: PAVIET-SALOMON, Bertrand, F-69006 Lyon (FR); GALL, Samuel, F-56610 Arradon (FR); LANTERNE, Adeline, F-24460 Saint Front D'alemps (FR); MANUEL, Sylvain, F-05230 Montgardin (FR)
(74) Mandataire: Cabinet Laurent & Charras
(86) Numéro de dépôt international: PCT/FR2012/052985
(87) Numéro de publication internationale: WO 2013/102718

(56) Documents cités:
- US-A1- 2009 227 094
- US-A1- 2011 177 652
- DANIEL L MEIER ET AL: "N-Type, Ion-Implanted Silicon Solar Cells and Modules", IEEE JOURNAL OF PHOTOVOLTAICS, I E E E, US, vol. 1, no. 2, 1 octobre 2011 (2011-10-01) , pages 123-129, XP011390839, ISSN: 2156-3381, DOI: 10.1109/JPHOTOV.2011.2169944
- AJEET ROHATGI ET AL: "High-Throughput Ion-Implantation for Low-Cost High-Efficiency Silicon Solar Cells", ENERGY PROCEDIA, vol. 15, 1 janvier 2012 (2012-01-01), pages 10-19, XP055043120, ISSN: 1876-6102, DOI: 10.1016/j.egypro.2012.02.002
- R. T. YOUNG: "Laser processing for high-efficiency Si solar cells", JOURNAL OF APPLIED PHYSICS, vol. 53, no. 2, 1 janvier 1982 (1982-01-01), pages 1178-1189, XP055043130, ISSN: 0021-8979, DOI: 10.1063/1.330568
- YOUGN R T ET AL: "HIGH-EFFICIENCY SI SOLAR CELLS BY BEAM PROCESSING", APPLIED PHYSICS LETTERS, AIP, AMERICAN INSTITUTE OF PHYSICS, MELVILLE, NY, US, vol. 43, no. 7, 1 octobre 1983 (1983-10-01), pages 666-668, XP000816497, ISSN: 0003-6951, DOI: 10.1063/1.94439

## Description

### DOMAINE DE L'INVENTION

L'invention a trait au domaine de la fabrication de microcomposants semi-conducteur comportant deux zones dopées par implantation de dopants et activations thermiques. L'invention s'applique tout particulièrement aux cellules photovoltaïques.

### ETAT DE LA TECHNIQUE

Schématiquement, une cellule photovoltaïque comporte un substrat semi-conducteur, usuellement réalisé en silicium dopé, par exemple dopé *p*, recouvert sur l'une de ses faces, usuellement la face avant destinée à recevoir le rayonnement, d'une couche dopée avec un dopage opposé, par exemple une couche dopée *n,* formant ainsi une jonction *pn* pour la collecte des photo-porteurs générés par l'illumination de la cellule. La couche n est par ailleurs recouverte d'une couche antireflet pour assurer une bonne absorption des photons, et des contacts électriques sont prévus dans la couche n pour la collecte du courant généré.

Afin d'améliorer le rendement de la cellule, une zone fortement dopée, du même type de dopage que le substrat, par exemple une couche dite *« p*⁺ » en raison de sa forte concentration en dopants de type *p*, est réalisée sur l'autre face du substrat. Cette zone est usuellement dénommée zone « BSF » (pour l'acronyme anglo-saxon *« Back Surface Field »).*

La couche n est par exemple réalisée au moyen d'une étape de diffusion gazeuse POCl₃ à une température de 850 - 950°C pendant plusieurs dizaines de minutes, comme cela est par exemple décrit dans le document de J. C.C. Tsai, "Shallow Phosphorus Diffusion Profiles in Silicon", Proc. of the IEEE 57 (9), 1969, pp. 1499-1506, ou au moyen d'un implantation ionique d'atomes de phosphore, suivie d'une étape d'activation thermique des atomes implantés, comme cela est par exemple décrit dans le document de D. L. Meier et al, "N-type, ion implanted silicon sonar cells and modules", Proc. 37th PVSC, 2011.

La couche « BSF » est réalisée par exemple en déposant une pâte de sérigraphie contenant de l'aluminium sur toute la face arrière du substrat. Une telle couche « BSF », dénommée « Al-BSF », est alors activée en procédant à son recuit, par exemple dans un four à passage à une température de 885 °C et avec une vitesse de tapis de 6500 mm/min, comme cela est par exemple décrit dans le document B. Sopori et al, "Fundamental mechanisms in the fire-through contact metallization of Si solar cells: a review", 17th Workshop on Crystalline Silicon Solar Cells & Modules: Materials and Process, Vail, Colorado, USA, August 5-8 2007

La couche « Al-BSF » pose cependant deux problèmes. Tout d'abord, le dépôt d'une pâte de sérigraphie sur toute la face arrière du substrat provoque une importante courbure de ce dernier lors du recuit nécessaire à l'activation de la couche « Al-BSF », en raison des coefficients de dilatation thermique différents entre le silicium et la pâte de sérigraphie. Cet effet est d'autant plus marqué que les différentes couches en présence sont minces, ce qui est extrêmement préjudiciable à une bonne mise en module de cellules photovoltaïques fabriquées de cette manière, comme cela est par exemple décrit dans le document de F. Huster, "Aluminium-Bach surface field: bow investigation and elimination", Proc. 20th EUPVSEC, 2005. Ensuite, en raison de la faible solubilité de l'aluminium dans le silicium, l'effet de champ recherché qui motive la réalisation d'une couche « BSF » est faible, ce qui limite donc le gain en rendement procuré par l'« Al-BSF ».

Diverses alternatives à l'« Al-BSF » ont donc été étudiées afin de résoudre ces problèmes. Une méthode couramment employée consiste ainsi à utiliser une couche « BSF » à base de bore, communément nommée « B-BSF », en lieu et place de la couche d'« Al-BSF ». Une couche « B-BSF » peut être réalisée de manière similaire à la zone *n* en face avant du substrat, par exemple au moyen d'une diffusion gazeuse de type BCl₃ ou BBr₃, mais également au moyen d'une implantation d'atomes de bore, suivie d'une étape d'activation thermique des atomes implantés.

Ainsi donc, il peut être envisagé de réaliser une cellule photovoltaïque en utilisant une implantation ionique de phosphore pour la couche *n*, et une implantation ionique de bore pour le « B-BSF ». Le problème d'une telle cellule est que les températures du recuit thermique nécessaire à l'activation des atomes implantés sont très différentes pour le bore et le phosphore. Ainsi, pour le phosphore, des températures inférieures à 850 °C sont nécessaires, alors que le bore nécessite des températures supérieures à 1000 °C pour être activé. Afin de contourner cette difficulté, les deux implantations ioniques et leurs deux recuits thermiques respectifs sont réalisés de manière séparée. Tout d'abord, du bore est implanté sur la face arrière du substrat pour obtenir la couche BSF, puis l'ensemble ainsi obtenu est recuit à 1000 °C. Ensuite, le phosphore est implanté en face avant et l'ensemble obtenu est ensuite recuit à 850 °C, le bore n'étant pas ou peu impacté par cette étape « basse température ». On pourra par exemple consulter le document de D. L. Meier susmentionné pour plus de détails.

La mise en oeuvre d'étapes d'implantation et de recuits thermiques séparées présente cependant un certain nombre de désavantages. Notamment, les étapes d'implantation ionique nécessitent généralement d'être réalisées sous vide et en salle blanche afin de limiter les risques de contamination. Cette mise en oeuvre séparée, induite par l'incompatibilité des températures des activations thermiques, implique donc de briser le vide au moins une fois et impose de multiplier les manipulations des cellules photovoltaïques au cours des phases les plus critiques de leur fabrication en termes de contamination.

En outre, la mise en oeuvre de recuit thermique à très haute température (supérieure à 1000°C comme requis pour l'activation du bore) s'applique à tout le substrat et engendre une dégradation de la durée de vie volumique globale du substrat.

Le document US 2009/227094 A1 décrit un procédé de fabrication d'une cellule photovoltaïque dans lequel deux types différent de dopants sont implantés, respectivement en face avant et en face arrière du substrat. L'activation thermique de ces espèces dopantes est ensuite réalisée par une irradiation laser.

### EXPOSE DE L'INVENTION

L'un des buts de la présente invention est de proposer un procédé de fabrication d'une cellule photovoltaïque ayant ses deux faces dopées par implantation ionique et activation thermique, qui minimise les contraintes de fabrication induites par les températures d'activation thermique différentes, et notamment qui permette de ne pas avoir des implantations et des activations totalement séparées en cas d'incompatibilité des températures.

Un autre de but de l'invention est de proposer un procédé qui ne dégrade pas la durée de vie du substrat.

A cet effet, l'invention a pour objet un procédé de fabrication d'une cellule photovoltaïque consistant :
▪ à réaliser un substrat semi-conducteur comportant une première face et une deuxième face opposées ;
▪ à réaliser, sur la première face du substrat, une première zone semi-conductrice dopée par implantation de premiers éléments dopants dans l'épaisseur du substrat et par activation thermique des premiers éléments dopants implantés à une première température d'activation ;
▪ à réaliser, sur la deuxième face du substrat, une seconde zone semi-conductrice par implantation de seconds éléments dopants dans l'épaisseur du substrat et par activation thermique des seconds éléments dopants implantés à une seconde température d'activation inférieure à la première température d'activation.

Selon l'invention, le substrat présente une épaisseur supérieure à 50 micromètres, et au moins l'activation thermique des premiers éléments dopants est réalisée par une irradiation laser, les paramètres d'irradiation étant choisis de sorte que le rayonnement soit absorbé au maximum sur une profondeur correspondant au premier micromètre du substrat.

En d'autres termes, l'irradiation laser permet une élévation de température intense et localisée de la face irradiée (sur une profondeur de l'ordre de la profondeur d'absorption du rayonnement dans le substrat c'est-à- dire de l'ordre du micromètre), provoquant ainsi l'activation thermique des éléments dopants implantés dans la face irradiée. Par ailleurs, l'irradiation est localisée et le substrat dissipe la chaleur, de sorte que la face opposée à la face irradiée ne subit pas ou très peu de chauffage. Il est ainsi possible d'implanter dans cette autre face des éléments dopants sans que ces derniers subissent un chauffage trop important. Ainsi, il est possible d'implanter des atomes de bore sur une face du substrat et des atomes de phosphore sur l'autre face du substrat, et d'irradier au laser la face implantée en atomes de bore sans que la face implantée en atomes de phosphore ne subisse un chauffage trop excessif.

Selon un mode de réalisation, les activations thermiques sont réalisées une fois achevées les implantations ioniques. Notamment, les implantations ioniques sont réalisées dans une même enceinte sous vide, de sorte que le vide n'est pas brisé entre la réalisation de celles-ci. En variante, les implantations ioniques ne sont réalisées préalablement aux activations thermiques. L'implantation ionique d'éléments peut par exemple est suivie directement de leur activation thermique.

Selon un mode de réalisation, l'activation thermique des seconds éléments dopants est réalisée par un recuit thermique. En variante, cette activation thermique peut également être réalisée par une irradiation laser, notamment une étape d'irradiation distincte de l'étape d'irradiation activant les premiers éléments.

Selon un mode de réalisation, les premiers éléments dopant sont des atomes de bore, et les seconds éléments dopants sont des atomes de phosphore.

Selon un mode de réalisation, l'irradiation laser de la première face est réalisée avec un laser pulsé dont la longueur d'onde est comprise entre 150 nm et 600 nm, et dont la puissance surfacique est comprise entre 1 et 7 J/cm² avec une durée de pulse comprise entre 10 nanosecondes et 1 microseconde. Une telle irradiation permet d'obtenir une température élevée (de l'ordre de 1000 °C et au-delà) sur une profondeur inférieure au micromètre.

Notamment, l'irradiation laser de la première face comportant des atomes de bore implantés est une irradiation au moyen d'un laser pulsé de fluence de l'ordre de 3 J/cm² et de durée de l'ordre de 150 nanosecondes. Une telle irradiation laser permet notamment d'obtenir un chauffage supérieur à 1000 °C pour l'activation thermique des atomes de bore implantés dans l'une des faces du substrat.

Selon un mode de réalisation, le substrat, notamment en silicium, présente une épaisseur comprise entre 50 micromètres et 300 micromètres, et de préférence une épaisseur de 180 micromètres.

Selon un mode de réalisation, le substrat est un substrat semi-conducteur dopé *p,* la première zone semi-conductrice étant une zone dopée *n*, et la seconde zone semi-conductrice étant une zone dopée *p.*

En variante, le substrat est un substrat semi-conducteur dopé *n,* la première zone semi-conductrice étant une zone dopée *n,* et la seconde zone semi-conductrice étant une zone dopée *p.*

### BREVE DESCRIPTION DES FIGURES

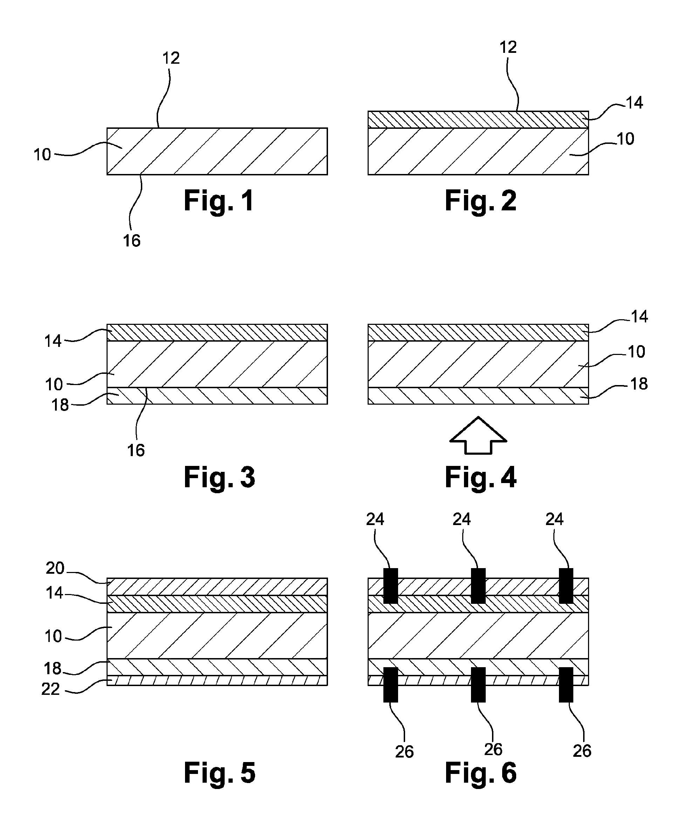

L'invention sera mieux comprise à la lecture de la description qui va suivre, donnée uniquement à titre d'exemple, et réalisée en relation avec les dessins annexés dans lesquels des références identiques désignent des éléments identiques et dans lesquels les figures 1 à 6 sont des vues schématiques en coupe illustrant un procédé de fabrication d'une cellule photovoltaïque conforme à l'invention.

### DESCRIPTION DETAILLEE DE L'INVENTION

En se référant aux figures 1 à 6, un procédé de fabrication d'une cellule photovoltaïque selon l'invention débute par la réalisation d'un substrat en silicium dopé *p* **10** (figure 1), d'épaisseur supérieure à 50 micromètres, notamment une épaisseur comprise entre 50 micromètres et 300 micromètres, par exemple 180 micromètres, optionnellement suivi de la texturation chimique de l'une **12** de ses faces, par exemple par application d'une solution de KOH à 1% à une température 80 °C pendant 40 min.

La face **12** est destinée à recevoir le rayonnement à convertir en courant, cette face est ci-après dénommée face « avant ».

Le procédé se poursuit par l'implantation ionique d'atomes de phosphore dans la face avant **12** (figure 2), par exemple une implantation de type POCl₃ avec une énergie comprise entre 5 et 50 keV, par exemple de 30 keV et une dose comprise entre 10¹⁴ at/cm² et 6.10¹⁵ at/cm², par exemple de 4.10¹⁵ at/cm² ou une immersion plasma, comme cela est connu en soi de l'état de la technique, de manière à obtenir une zone implantée en phosphore **14** sur la face avant **12** d'épaisseur typique inférieure à 100 nanomètres.

Ensuite, une implantation ionique d'atomes de bore est réalisée au sein de la face **16** ou face « arrière », opposée à la face avant **12** (figure 3), par exemple une implantation de type BCl₃ ou BBr₃ avec une énergie comprise entre 5 et 30 keV, par exemple de 10 keV et une dose comprise entre 10¹⁴ at/cm² et 5.10¹⁵ at/cm², par exemple de 3.10¹⁵ at/cm² ou une immersion plasma, comme cela est connu en soi de l'état de la technique, de manière à obtenir une zone implantée en bore **18** sur la face arrière **16** d'épaisseur typique inférieure à 100 nanomètres.

De préférence, les implantations ioniques de phosphore et de bore sont réalisées dans la même enceinte sous vide d'un dispositif d'implantation ionique, ce qui permet de ne pas briser le vide entre ces deux implantations et minimise ainsi le risque de contamination.

Le procédé se poursuit alors par l'irradiation de tout ou partie de la face arrière **16** avec un laser afin d'activer thermiquement et de faire diffuser en profondeur (typiquement inférieur à 500 nanomètres, par exemple de l'ordre de 200 nanomètres) les atomes de bore qui y sont implantés, réalisant ainsi une couche « B-BSF » sans endommager la face avant **12** et les atomes de phosphore qui s'y trouvent (figure 4). L'activation thermique des premiers éléments est réalisée avantageusement en irradiant la totalité de la face arrière **16** à l'aide d'un laser permettant une telle irradiation, notamment pendant une durée très courte.

Plus particulièrement, l'activation thermique des atomes de bore en face arrière est réalisée au moyen d'un laser excimer pulsé à 308 nanomètres, de durée des pulses égale à 150 nanosecondes, pulsé à 200 kHz et de densité d'énergie ou fluence égale à 3 J/cm², ce qui permet d'atteindre localement une température supérieure à 1000 °C. L'homme du métier saura adapter les paramètres d'irradiation en fonction du laser à sa disposition, il suffit que le rayonnement soit absorbé dans une épaisseur ou profondeur inférieure à un micromètre, et avantageusement inférieure à 500 ou 300 nanomètres, et que l'échauffement reste de l'ordre de 1000 °C (et en tout cas ne détériore pas le matériau).

Typiquement, l'irradiation laser pourra être réalisée avec un laser pulsé dont la longueur d'onde est comprise entre 150 nanomètres et 600 nanomètres, et dont la puissance surfacique est comprise entre 1 et 7 J/cm² avec une durée de pulse comprise entre 10 nanosecondes et 1 microseconde et une cadence de pulse comprise entre 1 kHz et 1 GHz.

L'activation thermique des atomes de phosphore implantés en face avant **12** est alors réalisée (figure 5), préférentiellement par recuit thermique à 840 °C dans un tube d'oxydation, ou par une irradiation laser, ou par un recuit rapide (ou recuit « RTP » pour l'acronyme anglo-saxon « *RAPID THERMAL PROCESSING* »)*.*

Une couche anti-reflet **20,** ayant également une fonction de passivation, est ensuite déposée sur la face avant **12** de la cellule, par exemple une couche de 75 nanomètres d'épaisseur de SiNₓ déposé par PECVD (« *Plasma Enhanced Chemical Vapor Deposition* ») de fréquence 440 kHz à une température de 450°C.

Une couche de passivation **22** est également déposée sur la face arrière **16,** par exemple une couche de 15 nanomètres d'épaisseur de SiNₓ déposée par PECVD de fréquence 440 kHz à une température de 450 °C.

Enfin, des contacts en face avant **24** et des contacts en face arrière **26,** avantageusement réalisés sous la forme de grilles, sont réalisés sur les faces avant **12** et arrière **16** de la cellule, puis un recuit desdits contacts **24, 26** est réalisé (figure 6).

Par exemple, une métallisation par sérigraphie de la face avant est réalisée avec une pâte d'argent déposée sur un masque comprenant un réseau d'ouvertures de 70 micromètres avec un pas de 2,1 millimètres, et une métallisation de la face arrière est réalisée avec une pâte d'aluminium déposée sur un masque comprenant des ouvertures de 70 micromètres avec un pas de 1 millimètre, puis le recuit des contacts en face avant et en face arrière est réalisé dans un four infrarouge de type Centrotherm, avec une température comprise entre 850 et 1050 °C et à une vitesse comprise entre 2000 et 6500 mm/min.

Il a été décrit une application de l'invention à la réalisation d'une cellule photovoltaïque ayant un substrat de type *p.* Le procédé s'applique également à une cellule photovoltaïque ayant un substrat de type *n* pour la fabrication d'une cellule dite « type *n* inversé ». Dans ce cas, la zone semi-conductrice dopée située en face arrière, et contenant du bore, joue le rôle d'émetteur, tandis que la zone semi-conductrice dopée en face avant, et contenant du phosphore, est une couche dite « FSF » (acronyme de l'expression anglaise « *Front Surface Field* ») qui joue, pour la face avant, un rôle équivalent à celui d'une couche « BSF » en face arrière.

L'invention s'applique également à la réalisation d'une structure de type n standard, c'est-à-dire comportant des émetteurs de type *p* en face avant, réalisés au moyen d'une implantation bore suivie d'une activation thermique par une irradiation laser telle que décrite précédemment, et compostant une couche « BSF » au phosphore implantée en face arrière, obtenue par implantation et activation thermique classiques, ou une implantation classique et une activation par irradiation laser.

Le procédé selon l'invention s'applique également à la réalisation d'émetteur sélectif en face avant pour les cellules photovoltaïques à substrat de type p, ou à une couche FSF sélectif dans le cas des cellules de type n inversé), et/ou une couche BSF localisé en face arrière de cellules photovoltaïques.

## Revendications

1. Procédé de fabrication d'une cellule photovoltaïque consistant :
▪ à réaliser un substrat semi-conducteur (10) comportant une première face (12) et une deuxième face (16) opposées;
▪ à réaliser, sur la première face (12) du substrat (10), une première zone semi-conductrice (14) dopée par l'implantation de premiers éléments dopants dans l'épaisseur du substrat et par l'activation thermique des premiers éléments dopants implantés à une première température d'activation ;
▪ à réaliser, sur la deuxième face (16) du substrat (10), une seconde zone semi-conductrice (18) par l'implantation de seconds éléments dopants dans l'épaisseur du substrat et par l'activation thermique des seconds éléments dopants implantés à une seconde température d'activation inférieure à la première température d'activation;
***caractérisé* en ce que** le substrat présente une épaisseur supérieure à 50 micromètres, et **en ce qu'**au moins l'activation thermique des premiers éléments dopants est réalisée par une irradiation laser, les paramètres d'irradiation étant choisis afin que le rayonnement soit absorbé au plus dans une profondeur du premier micromètre du substrat.

2. Procédé de fabrication d'une cellule photovoltaïque selon la revendication 1, ***caractérisé* en ce que** les activations thermiques sont réalisées une fois achevées les implantations ioniques.

3. Procédé de fabrication d'une cellule photovoltaïque selon la revendication 1 ou 2, ***caractérisé* en ce que** l'activation thermique des seconds éléments dopants est réalisée par un recuit thermique ou par une irradiation laser.

4. Procédé de fabrication d'une cellule photovoltaïque selon l'une quelconque des revendications précédentes, ***caractérisé* en ce que** les premiers éléments dopants sont des atomes de bore, et **en ce que** les seconds éléments dopants sont des atomes de phosphore.

5. Procédé de fabrication d'une cellule photovoltaïque selon l'une quelconque des revendications précédentes, ***caractérisé* en ce que** l'irradiation laser de la première face est une irradiation laser, dont la longueur d'onde est comprise entre 150 nanomètres et 600 nanomètres.

6. Procédé de fabrication d'une cellule photovoltaïque selon l'une quelconque des revendications précédentes, ***caractérisé* en ce que** l'irradiation laser de la première face comportant des atomes de bore implantés est une irradiation par laser pulsé de fluence comprise entre 1 et 7 J/cm² avec une durée de pulse comprise entre 10 nanosecondes et 1 microseconde.

7. Procédé de fabrication d'une cellule photovoltaïque selon l'une quelconque des revendications précédentes, ***caractérisé* en ce que** le substrat, notamment en silicium, présente une épaisseur comprise entre 50 micromètres et 300 micromètres, de préférence une épaisseur de 180 micromètres.

8. Procédé de fabrication d'une cellule photovoltaïque selon l'une quelconque des revendications précédentes, ***caractérisé* en ce que** le substrat est un substrat semi-conducteur dopé p, **en ce que** la première zone semi-conductrice est une zone dopée n, et **en ce que** la seconde zone semi-conductrice est une zone dopée p.

9. Procédé de fabrication d'une cellule photovoltaïque selon l'une quelconque des revendications 1 à 7, ***caractérisé* en ce que** le substrat est un substrat semi-conducteur dopé n, **en ce que** la première zone semi-conductrice est une zone dopée n, et **en ce que** la seconde zone semi-conductrice est une zone dopée p.

## Patentansprüche

1. Verfahren zur Herstellung einer Fotovoltaikzelle, darin bestehend:
▪ ein Halbleitersubstrat (10) mit einer ersten Fläche (12) und einer zweiten Fläche (16) zu schaffen, die zueinander entgegengesetzt sind;
▪ auf der ersten Fläche (12) des Substrats (10) eine erste dotierte Halbleiterzone (14) durch Implantation erster Dotierelemente in die Dicke des Substrats und durch thermische Aktivierung der implantierten ersten Dotierelemente bei einer ersten Aktivierungstemperatur zu schaffen;
▪ auf der zweiten Fläche (16) des Substrats (16) eine zweite Halbleiterzone (18) durch Implantation zweiter Dotierelemente in die Dicke des Substrats und durch thermische Aktivierung der implantierten zweiten Dotierelemente bei einer zweiten Aktivierungstemperatur zu schaffen, die niedriger ist als die erste Aktivierungstemperatur;
**dadurch gekennzeichnet, dass** das Substrat eine Dicke von über 50 Mikrometer aufweist, und dass zumindest die thermische Aktivierung der ersten Dotierelemente durch eine Laserbestrahlung erfolgt, wobei die Bestrahlungsparameter ausgewählt werden, damit die Strahlung höchstens in einer Tiefe des ersten Mikrometers des Substrats absorbiert wird.

2. Verfahren zur Herstellung einer Fotovoltaikzelle nach Anspruch 1, **dadurch gekennzeichnet, dass** die thermischen Aktivierungen erfolgen, sobald die Ionenimplantationen aufhören.

3. Verfahren zur Herstellung einer Fotovoltaikzelle nach Anspruch 1 oder 2, **dadurch gekennzeichnet, dass** die thermische Aktivierung der zweiten Dotierelemente durch ein thermisches Tempern oder durch eine Laserbestrahlung erfolgt.

4. Verfahren zur Herstellung einer Fotovoltaikzelle nach einem der vorhergehenden Ansprüche, **dadurch gekennzeichnet, dass** die ersten Dotierelemente Boratome und die zweiten Dotierelemente Phosphoratome sind.

5. Verfahren zur Herstellung einer Fotovoltaikzelle nach einem der vorhergehenden Ansprüche, **dadurch gekennzeichnet, dass** die Laserbestrahlung der ersten Fläche eine Laserbestrahlung ist, deren Wellenlänge zwischen 150 Nanometer und 600 Nanometer beträgt.

6. Verfahren zur Herstellung einer Fotovoltaikzelle nach einem der vorhergehenden Ansprüche, **dadurch gekennzeichnet, dass** die Laserbestrahlung der ersten Fläche, die implantierte Boratome umfasst, eine Bestrahlung durch gepulsten Laser mit einem Energiefluss zwischen 1 und 7 J/cm² bei einer Pulsdauer zwischen 10 Nanosekunden und einer Mikrosekunde ist.

7. Verfahren zur Herstellung einer Fotovoltaikzelle nach einem der vorhergehenden Ansprüche, **dadurch gekennzeichnet, dass** das Substrat, insbesondere aus Silicium, eine Dicke zwischen 50 Mikrometer und 300 Mikrometer, vorzugsweise eine Dicke von 180 Mikrometer aufweist.

8. Verfahren zur Herstellung einer Fotovoltaikzelle nach einem der vorhergehenden Ansprüche, **dadurch gekennzeichnet, dass** das Substrat ein p-dotiertes Halbleitersubstrat ist, dass die erste Halbleiterzone eine n-dotierte Zone ist, und dass die zweite Halbleiterzone eine p-dotierte Zone ist.

9. Verfahren zur Herstellung einer Fotovoltaikzelle nach einem der Ansprüche 1 bis 7, **dadurch gekennzeichnet, dass** das Substrat ein n-dotiertes Halbleitersubstrat ist, wobei die erste Halbleiterzone ein n-dotierte Zone ist, und wobei die zweite Halbleiterzone eine p-dotierte Zone ist.

## Claims

1. A method for manufacturing a photovoltaic cell comprising:
▪ forming a semiconductor substrate (10) comprising opposite first (12) and second (16) surfaces;
▪ forming, on the first surface (12) of the substrate (10), a first semiconductor area (14) doped by implantation of first dopant elements across the substrate thickness and by thermal activation of the first implanted dopant elements at a first activation temperature;
▪ forming, on the second surface (16) of the substrate (10), a second semiconductor area (18) doped by implantation of second dopant elements across the substrate thickness and by thermal activation of the second implanted dopant elements at a second activation temperature lower than the first activation temperature;
***characterized* in that** the substrate has a thickness greater than 50 micrometers, and **in that** at least the thermal activation of the first dopant elements is performed by laser irradiation, the irradiation parameters being selected so that the radiation is absorbed at most down to a depth of the first micrometer of the substrate.

2. The photovoltaic cell manufacturing method of claim 1, ***characterized* in that** the thermal activations are performed once the ion implantations have been completed.

3. The photovoltaic cell manufacturing method of claim 1 or 2, ***characterized* in that** the thermal activation of the second dopant elements is performed by a thermal anneal or by a laser irradiation.

4. The photovoltaic cell manufacturing method of any of the foregoing claims, ***characterized* in that** the first dopant elements are boron atoms, and **in that** the second dopant elements are phosphorus atoms.

5. The photovoltaic cell manufacturing method of any of the foregoing claims, ***characterized* in that** the laser irradiation of the first surface is a laser irradiation with a wavelength in the range from 150 nanometers to 600 nanometers.

6. The photovoltaic cell manufacturing method of any of the foregoing claims, ***characterized* in that** the laser irradiation of the first surface comprising implanted boron atoms is an irradiation by pulsed laser having a fluence in the range from 1 to 7 J/cm² with a pulse duration in the range from 10 nanoseconds to 1 microsecond.

7. The photovoltaic cell manufacturing method of any of the foregoing claims, ***characterized* in that** the substrate, particularly made of silicon, has a thickness in the range from 50 micrometers to 300 micrometers, preferably a thickness of 180 micrometers.

8. The photovoltaic cell manufacturing method of any of the foregoing claims, ***characterized* in that** the substrate is a p-doped semiconductor substrate, **in that** the first semiconductor area is an n-doped area, and **in that** the second semiconductor area is a p-doped area.

9. The photovoltaic cell manufacturing method of any of claims 1 to 7, ***characterized* in that** the substrate is an n-doped semiconductor substrate, **in that** the first semiconductor area is an n-doped area, and **in that** the second semiconductor area is a p-doped area.
